# EUROPEAN PATENT APPLICATION

(11) **EP 4 564 647 A1**
(43) Date of publication of application: **04.06.2025**
(21) Application number: 24213594.5
(22) Date of filing: 18.11.2024
(51) Int. Cl.: H02J 7/00, B25H 1/00, B25F 5/00

(54) **VOLTAGE DETECTION CIRCUIT ASSEMBLY FOR A BATTERY PACK OF A POWER TOOL**

(30) Priority: 28.11.2023 US 202363603326 P
(71) Applicant: Milwaukee Electric Tool Corporation, Brookfield, WI 53005-2550 (US)
(72) Inventor: Casper, Maxwell A., Brookfield, Wisconsin, 53005-2550 (US); Behnke, Richard, Brookfield, Wisconsin, 53005-2550 (US)
(74) Representative: Grünecker Patent- und Rechtsanwälte PartG mbB

(57) **Abstract**

A battery pack configured to supply power to a common load includes at least one battery having a high side battery interface and a low side battery interface. The high side and low side battery interfaces are electrically coupled to the common load. The battery pack further includes a voltage detection circuit assembly configured to perform a plurality of operations, including but not limited to determining whether to implement a hardware trigger on only the high side battery interface by referencing ground of the low side battery interface, detecting a load type of the common load based on whether the high side battery interface is triggered, sending a notification to the high side battery interface and the low side battery interface as to whether the high side battery interface is triggered, and in response to sending the notification, determining whether to allow firmware to operate the common load.

## Description

### FIELD

The present disclosure relates generally to handheld power tools, and more particularly to an isolated voltage detection circuit for a battery pack of a handheld power tool.

### BACKGROUND

Portable battery-powered tools may rely on a rechargeable battery pack for power. The battery pack can connect directly to the tool (i.e., inserted into the tool) or may be configured as a self-contained unit that is carried by a user and electrically tethered to the tool, such as a backpack or carry-on battery pack. As the use and convenience of portable tools grows, so does the demand for increased power density and efficiency from these battery packs to provide more power and a longer run time for the tool.

The battery packs may be periodically charged in a compatible battery charger. These battery packs range in battery chemistry and nominal voltage and can be used to power numerous tools and electrical devices. In this regard, the use of lithium-ion (Li-ion) batteries in the battery packs has grown due in large part to the increased power density characteristics of these batteries. Multiple Li-ion batteries may be combined in parallel in the battery packs to increase the capacity of the packs even further. Moreover, the use of back-to-back MOSFETs connected in series between a Li-ion battery pack and the output load is a known configuration in conventional battery protection circuits. An integrated circuit (IC) controls the on/off state of the MOSFETs and the charge and discharge modes of the battery.

In certain instances, the battery packs are intended to work with only certain tools that use a common battery interface. However, such battery packs do not have a means for distinguishing between different types of power tools. For example, some battery packs include a series battery connection to achieve a higher voltage, yet the batteries therein remain isolated systems. The backpack supply must copy the isolated system to prevent potential Failure Mode and Effects Analysis (FMEA) and user error concerns. However, existing systems do not have a way to detect if the batteries are connected to a high side or a low side of the system.

### BRIEF DESCRIPTION

Aspects and advantages of the invention in accordance with the present disclosure will be set forth in part in the following description, or may be obvious from the description, or may be learned through practice of the technology.

In an aspect, the present disclosure is directed to a battery pack configured to supply power to a common load. The battery pack includes at least one battery having a high side battery interface and a low side battery interface. The high side and low side battery interfaces are electrically coupled to the common load. The battery pack further includes a voltage detection circuit assembly configured to perform a plurality of operations, including but not limited to determining whether to implement a hardware trigger on only the high side battery interface by referencing ground of the low side battery interface, detecting a load type of the common load based on whether the high side battery interface is triggered, sending a notification to the high side battery interface and the low side battery interface as to whether the high side battery interface is triggered, and in response to sending the notification, determining whether to allow firmware to operate the common load.

In another aspect, the present disclosure is directed to a method for detecting voltage of a load connected to a battery pack. The method includes determining, via a voltage detection circuit assembly, whether to implement a hardware trigger on only a high side battery interface of the battery pack by referencing ground of a low side battery interface of the battery pack. The method further includes detecting, via the voltage detection circuit assembly, a load type of the load based on whether the high side battery interface is triggered. Moreover, the method includes sending, via the voltage detection circuit assembly, a notification to the high side battery interface and the low side battery interface as to whether the high side battery interface is triggered. In response to sending the notification, the method includes determining, via the voltage detection circuit assembly, whether to allow firmware of the battery pack to operate the load.

These and other features, aspects and advantages of the present invention will become better understood with reference to the following description and appended claims. The accompanying drawings, which are incorporated in and constitute a part of this specification, illustrate embodiments of the technology and, together with the description, serve to explain the principles of the technology.

### BRIEF DESCRIPTION OF THE DRAWINGS

A full and enabling disclosure of the present invention, including the best mode of making and using the present systems and methods, directed to one of ordinary skill in the art, is set forth in the specification, which makes reference to the appended figures, in which:
FIG. 1 illustrates a schematic view of an embodiment of a battery pack having a first battery and a second battery according to the present disclosure;
FIGS. 2A and 2B illustrate a configuration of a conventional battery protection circuit that utilizes a back-to-back MOSFET;
FIGS. 3A and 3B illustrate various schematic diagrams of an embodiment of a system for supplying power to a common load according to the present disclosure;
FIG. 4 illustrates a flow diagram of an embodiment of a method for detecting voltage of a load connected to a battery pack via a voltage detection circuit assembly according to the present disclosure;
FIG. 5 illustrates a simplified, schematic diagram of an embodiment of a voltage detection circuit assembly according to the present disclosure;
FIGS. 6A and 6B illustrate simplified, schematic diagrams of an embodiment of a voltage detection circuit assembly according to the present disclosure;
FIG. 7 illustrates a schematic diagram of an embodiment of a system for supplying power to a common load according to the present disclosure, particularly illustrating batteries of the system disconnected from each other;
FIG. 8 illustrates a schematic diagram of an embodiment of a voltage detection circuit assembly according to the present disclosure;
FIG. 9 illustrates a schematic diagram of an embodiment of a voltage detection circuit assembly according to the present disclosure; and
FIG. 10 illustrates a schematic diagram of an embodiment of a voltage detection circuit assembly according to the present disclosure.

### DETAILED DESCRIPTION

Reference now will be made in detail to embodiments of the present invention, one or more examples of which are illustrated in the drawings. The word "exemplary" is used herein to mean "serving as an example, instance, or illustration." Any implementation described herein as "exemplary" is not necessarily to be construed as preferred or advantageous over other implementations. Moreover, each example is provided by way of explanation, rather than limitation of, the technology. In fact, it will be apparent to those skilled in the art that modifications and variations can be made in the present technology without departing from the scope or spirit of the claimed technology. For instance, features illustrated or described as part of one embodiment can be used with another embodiment to yield a still further embodiment. Thus, it is intended that the present disclosure covers such modifications and variations as come within the scope of the appended claims and their equivalents. The detailed description uses numerical and letter designations to refer to features in the drawings. Like or similar designations in the drawings and description have been used to refer to like or similar parts of the invention.

As used herein, the terms "first", "second", and "third" may be used interchangeably to distinguish one component from another and are not intended to signify location or importance of the individual components. The singular forms "a," "an," and "the" include plural references unless the context clearly dictates otherwise. The terms "coupled," "fixed," "attached to," and the like refer to both direct coupling, fixing, or attaching, as well as indirect coupling, fixing, or attaching through one or more intermediate components or features, unless otherwise specified herein. As used herein, the terms "comprises," "comprising," "includes," "including," "has," "having" or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive- or and not to an exclusive- or. For example, a condition A or B is satisfied by any one of the following: A is true (or present) and B is false (or not present), A is false (or not present) and B is true (or present), and both A and B are true (or present).

Terms of approximation, such as "about," "generally," "approximately," or "substantially," include values within ten percent greater or less than the stated value. When used in the context of an angle or direction, such terms include within ten degrees greater or less than the stated angle or direction. For example, "generally vertical" includes directions within ten degrees of vertical in any direction, e.g., clockwise or counterclockwise.

As used herein, the term "power tool" is intended to refer to a device which is used to perform a work operation, such as trimming objects like branches; cutting materials like wood, metal, concrete, grass, or the like; biasing fluids like air and water; and the like. By way of non-limiting example, power tools can include hedge trimmers, chainsaws, circular saws, reciprocating saws, grinders, pruners, string trimmers, lawnmowers, edgers, blowers, vacuums, snow throwers, mixers, augers, pumps, pipe threaders, drills, and impact wrenches. While embodiments provided below are directed to hedge trimmers, one or more components of the hedge trimmer described below, such as the single-piece crankshaft, may be utilized with one or more different types of power tools.

Benefits, other advantages, and solutions to problems are described below with regard to specific embodiments. However, the benefits, advantages, solutions to problems, and any feature(s) that may cause any benefit, advantage, or solution to occur or become more pronounced are not to be construed as a critical, required, or essential feature of any or all the claims.

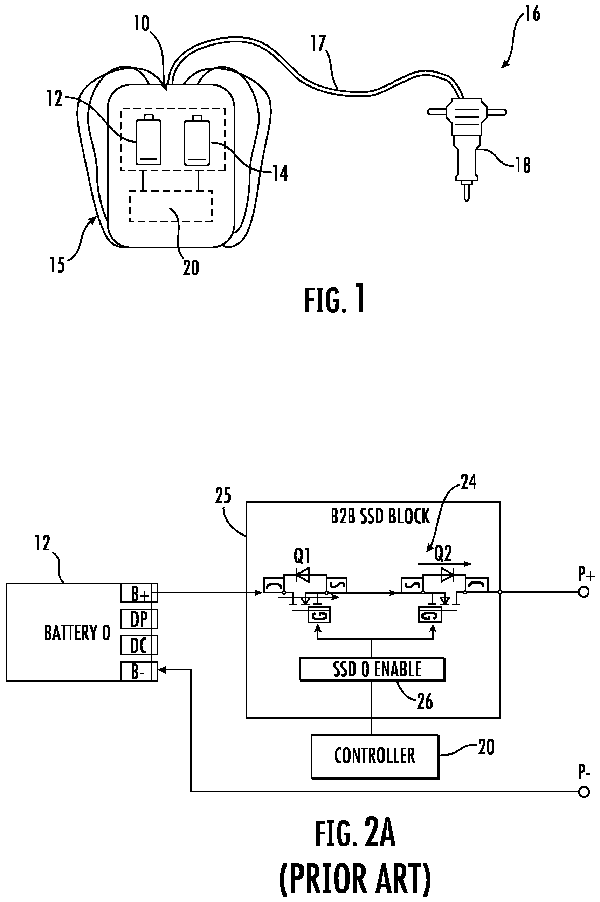

Referring now to FIG. 1, a battery pack 10 having a first battery 12, a second battery 14, and a controller 20 is depicted. The battery pack 10 is configured within a backpack 15 that can be worn by a user and is electrically connected to a power tool 18 via an electrical tether 17 to supply power to the power tool 18. FIG. 1 merely depicts a known use of a battery pack 10 and is not intended as a limitation of the invention. It should be appreciated that the battery pack 10 incorporating aspects of the present invention can be configured with any embodiment wherein multiple batteries are provided in parallel to deliver power to a load, such as a power tool. Furthermore, the batteries 12 and 14 are described herein as Li-ion batteries for ease of explanation only. The present disclosure is not limited to use with Li-ion batteries.

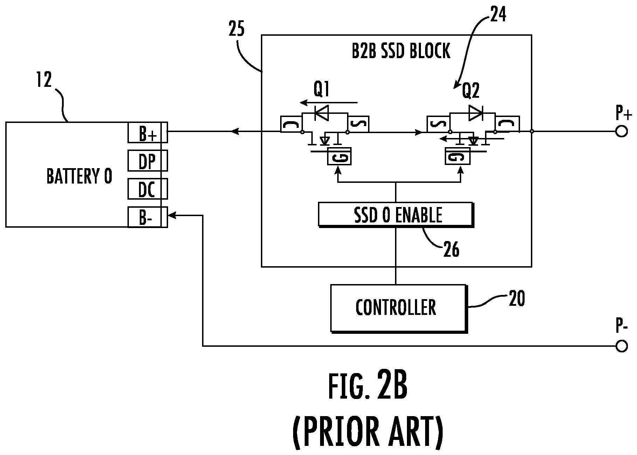

FIGS. 2A and 2B depict a configuration of a conventional battery protection circuit that utilizes a back-to-back MOSFET structure and are discussed herein to provide a background reference for the present disclosure.

Referring to FIGS. 2A and 2B, the back-to-back MOSFET structure includes two power MOSFETs 24 and a driver 26 implemented with a solid state drive (SSD) within the controller 20 or otherwise in communication with the controller 20. Moreover, as shown, the MOSFETs 24 are connected in series between the Li-ion battery 12 and the output load. The controller 20 may be a dedicated IC (integrated circuit) used to control gating (i.e., the on and off states) of the MOSFETs 24 for managing the charge and discharge modes of the battery 12. One of the MOSFETs 24 (e.g., Q1) is used for discharging the battery 12 to supply power to the load (FIG. 2A) and the other MOSFET 24 (e.g., Q2) is used for charging (FIG. 2B) the battery 12. The MOSFETs 24 are depicted at the positive ("high-end") of the battery 12. In other embodiments, the MOSFETs 24 may be located at the negative ("low-end") of the battery 12. The MOSFETs 24 may be P-channel or N-channel MOSFETs, and the drains may be connected in the back-to-back structure, as depicted in FIGS. 2A and 2B.

In the discharge mode of the battery 12 depicted in FIG. 2A, the IC controller 20 provides the gate drive signal to the driver 26 to drive the discharge MOSFET Q1 to the high (on) state. When Q1 is on, the discharge path (indicated by the arrows in FIG. 2A) is through Q1, across the parasitic diode around Q2, and to the load. In a certain embodiment, the controller 20 may also turn on Q2 (which has a lower resistance than the parasitic diode around Q2) in order to avoid the conduction loss (voltage drop) from the parasitic diode.

In the charging mode of the battery 12 depicted in FIG. 2B, the IC controller 20 provides the gate drive signal to the driver 26 to drive the charging MOSFET Q2 to the high (on) state. When Q2 is on, the charging path (indicated by the arrows in FIG. 2B) is through Q2, across the parasitic diode around Q1, and to the battery 12. In a certain embodiment, the controller 20 may also turn on Q1 (which has a lower resistance than the parasitic diode around Q1) in order to avoid the avoid the conduction loss (voltage drop) from the parasitic diode.

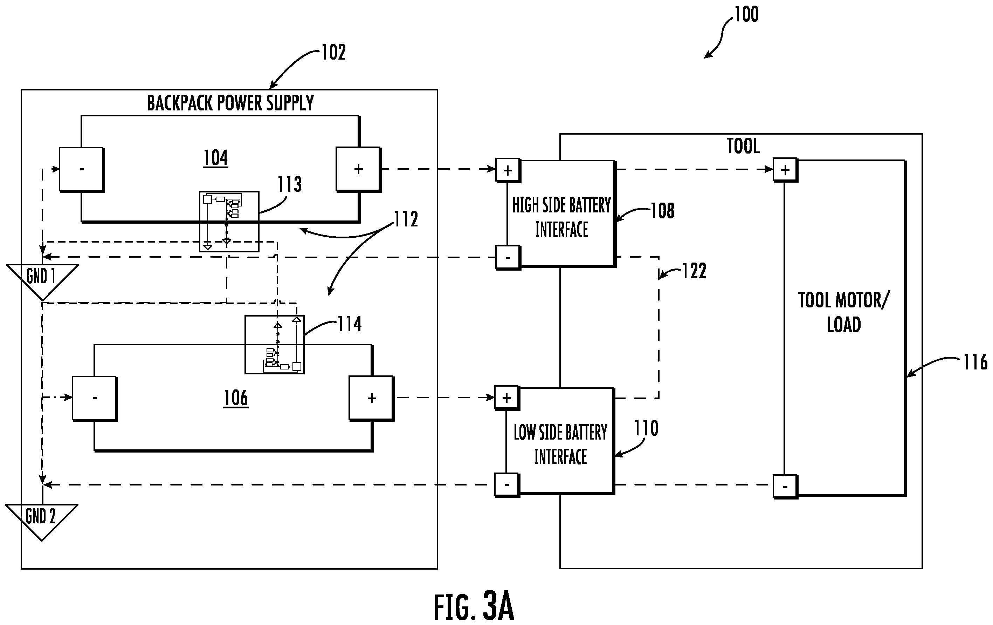

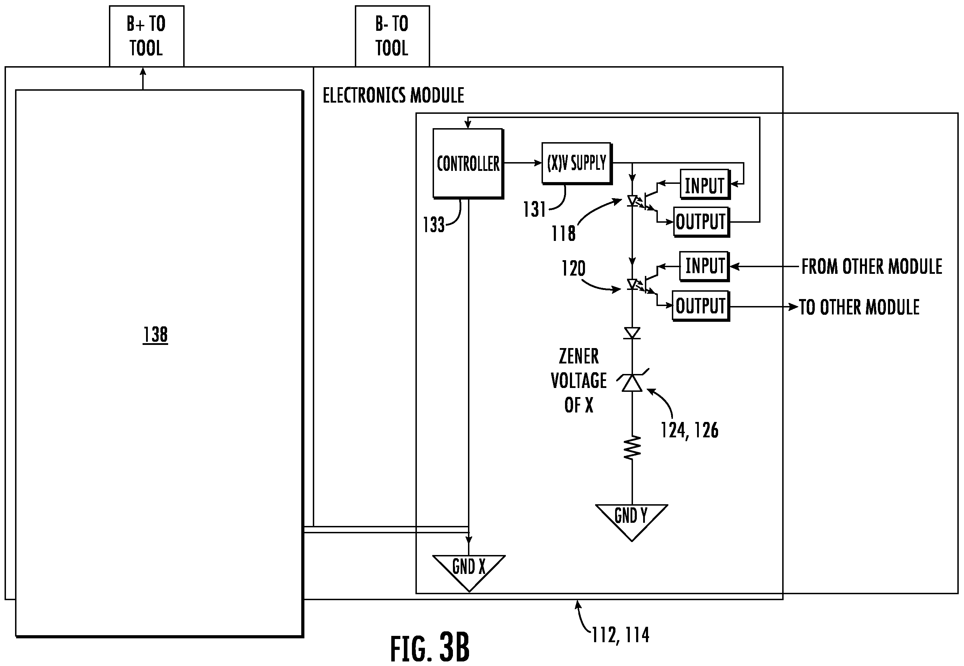

Referring now to FIGS. 3A and 3B, various schematic diagrams of an embodiment of a system 100 for supplying power to a common load 116 according to the present disclosure are illustrated. For example, in an embodiment, the common load 116 may be a power tool, such as any suitable handheld power tool. More specifically, as shown, the system 100 includes a battery pack 102 having at least one battery 104, 106 connected to the common load 116 via a high side battery interface 108 and a low side battery interface 110. For example, as shown, the battery pack 102 includes a first battery 104 and a second battery 106 that are together electrically coupled to the common load 116 via the high side battery interface 108 and the low side battery interface 110. In addition, as shown in FIGS. 3A and 3B, the battery pack 102 further includes at least voltage detection circuit assembly 112 electrically coupled to each of the batteries 104, 106. Moreover, in an embodiment, as shown in FIG. 3A, each voltage detection circuit assembly 112 includes a first circuit 113 and a second circuit 114. For example, FIG. 3B illustrates a schematic diagram of an embodiment of the second circuit 114. Furthermore, as shown in FIGS. 3B, 5, 6A, and 6B, the first and second circuits 113, 114 include a first diode 124 and a second diode 125, respectively, and one or more first isolators 119, 121 and second isolators 118, 120, respectively. In such embodiments, as an example, the first and second isolator(s) 118, 119, 120, 121 may be optocouplers, whereas the first and second diodes 124, 125 may be Zener diodes 126, 127, respectively.

Further, as shown in the illustrated embodiment, the first battery 104 is connected to a positive side (+) of the high side battery interface 108 and the second battery is connected to a positive side (+) of the low side battery interface 110. Moreover, in the illustrated embodiment, V_{GND2} is less than V_{GND1}. In such embodiments, the difference in the reference voltage is driven by a tool side series connection 122 that connects the otherwise isolated modules (e.g., the first and second batteries 104, 106). By referencing the isolated voltage detection circuit assembly 112 to both the other modules (e.g., the first and second batteries 104, 106) B- voltage (e.g., the corresponding GND(X)), the voltage detection circuit assembly 112 can be an automatically triggered circuit that only trips in the presence of a stacked battery voltage (which can also be enforced by sizing of the Zener diode 126).

In an embodiment, as shown, the voltage detection circuit assembly 112 operates as a Boolean signal to a controller 138 (FIG. 3B) if the voltage detection circuit assembly 112 is active (i.e., current is flowing through the voltage detection circuit assembly 112) or inactive (i.e., current is not flowing through the voltage detection circuit assembly 112). In an embodiment, for example, as shown in FIG. 3A, the positive side of the low side battery interface 110 is connected to the negative side of the high side battery interface 108 and the negative side of the low side battery interface 110 to ground (GND2). Thus, in an embodiment, as shown in FIG. 3B, the voltage detection circuit assembly 112 is active when X(V) supply 131 is greater than Vzener (referred to herein as a voltage threshold). Accordingly, if the voltage detection circuit assembly 112 is active, the circuit assembly 112 will activate a series pair of optocouplers (e.g., optocouplers 118, 120) which are isolated to: the ON board electronics module (e.g., a controller 133 on the electronics module of the voltage detection circuit assembly 112) and the OFF board electronics module (e.g., a controller on another electronics module such as part of the first circuit 113).

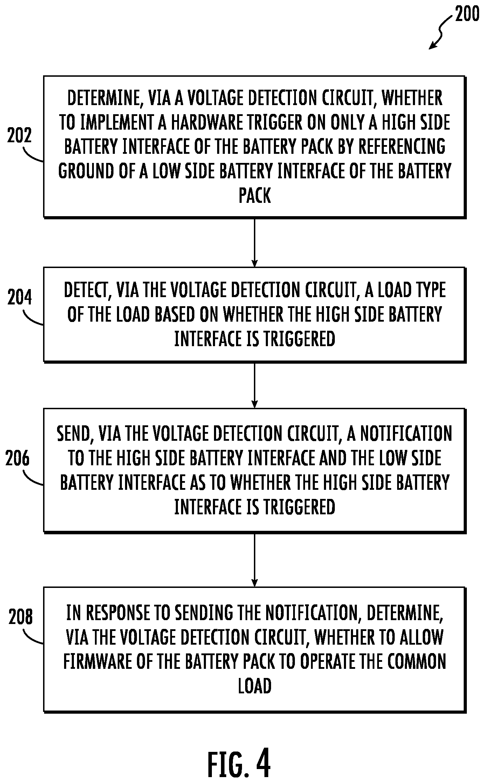

Referring now to FIG. 4, a flow diagram of an embodiment of a method 200 for detecting voltage of a load, such as the common load 116, connected to the battery pack 102 via the voltage detection circuit assembly 112 is illustrated according to the present disclosure. As shown at (202), the method 200 includes determining, via the voltage detection circuit assembly 112, whether to implement a hardware trigger on only the high side battery interface 108 by referencing ground of the low side battery interface 110. For example, in an embodiment, determining whether to implement the hardware trigger on only the high side battery interface 108 by referencing the ground of the low side battery interface 110 may include comparing a voltage at the high side battery interface 108 and a voltage at the low side battery interface 110 to a voltage threshold (e.g., Vzener) and implementing the hardware trigger on only the high side battery interface 108 when the voltage at the high side battery interface 108 exceeds the voltage threshold.

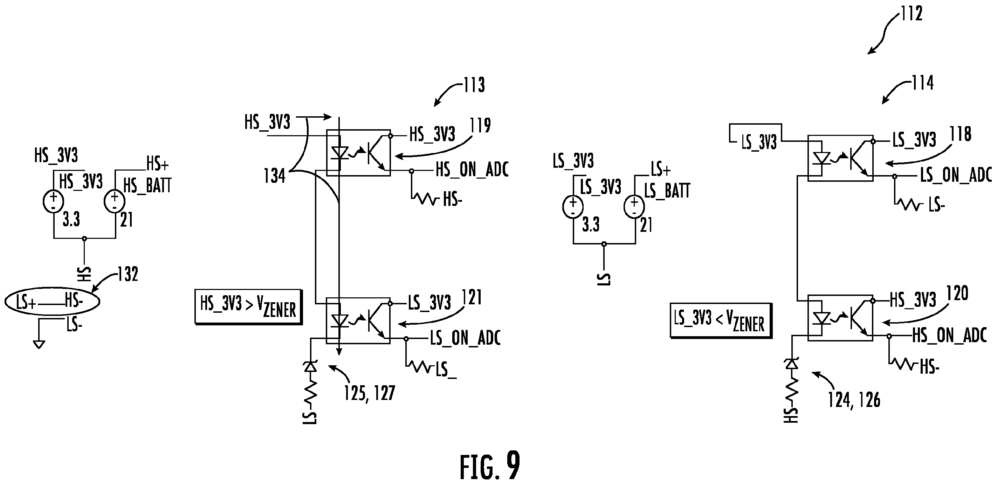

More specifically, in an embodiment, determining whether to implement the hardware trigger on only the high side battery interface 108 by referencing the ground of the low side battery interface may include triggering the first isolator(s) 119, 121 when the voltage of the high side battery interface 108 exceeds the voltage threshold and the voltage at the low side battery interface 110 is below the voltage threshold. Furthermore, in an embodiment, triggering the first isolator(s) 119, 121 when the voltage of the high side battery interface 108 exceeds the voltage threshold and the voltage at the low side battery interface 110 is below the voltage threshold may include using the first Zener diode 127 of the first circuit 113 to trigger the first isolator(s) 119, 121 by allowing current through the first isolator(s) 119, 121 and using the second Zener diode 126 of the second circuit 114 to prevent current from flowing through the second isolator(s) 118, 120, which is further illustrated and explained with respect to FIG. 9.

Referring still to FIG. 4, as shown at (204), the method 200 includes detecting, via the voltage detection circuit assembly 112, a load type of the load 116 based on whether the high side battery interface 108 is triggered. For example, in an embodiment, the load type may include an 18-volt power tool or a 36-volt power tool. As shown at (206), the method 200 includes sending, via the voltage detection circuit assembly 112, a notification to the high side battery interface 108 and the low side battery interface 110 as to whether the high side battery interface 108 is triggered. In response to sending the notification, as shown at (208), the method 300 includes determining, via the voltage detection circuit assembly 112, whether to allow firmware of the battery pack 102 to operate the common load 116. For example, in an embodiment, determining whether to allow firmware to operate the common load may include allowing the firmware to operate the common load when the high side battery interface is triggered or preventing the firmware from operating the common load when the high side battery interface is not triggered.

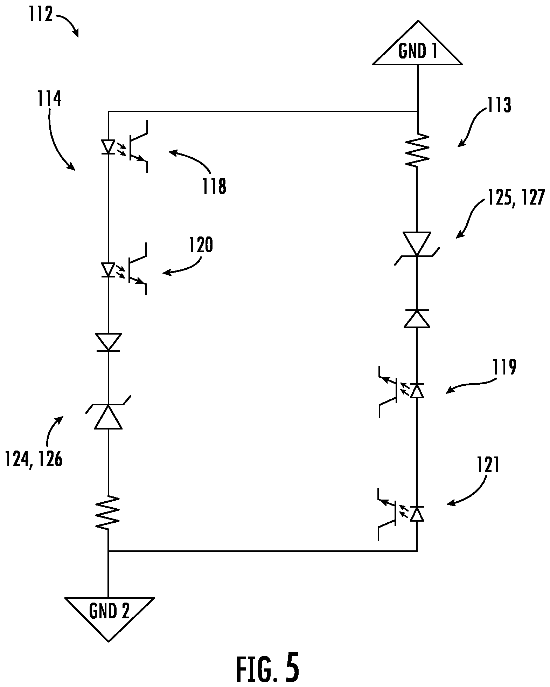

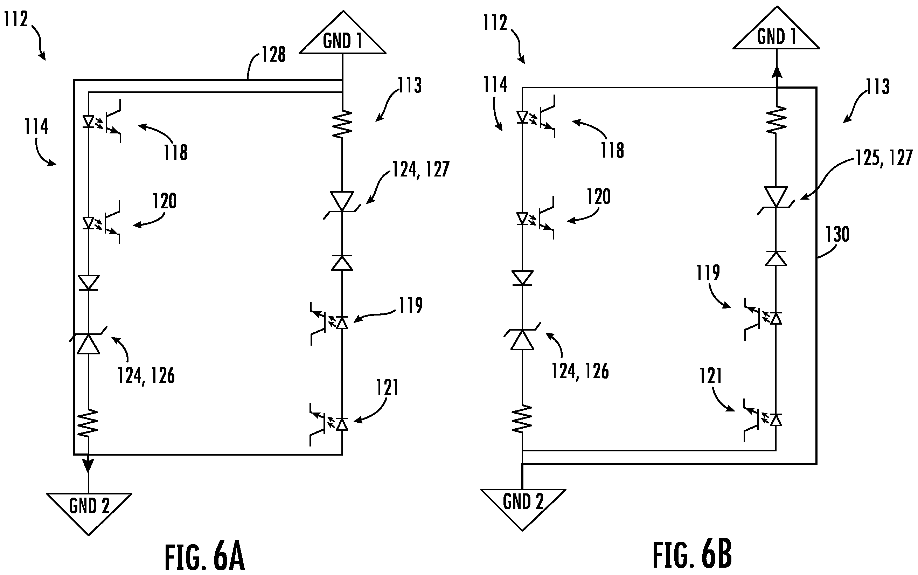

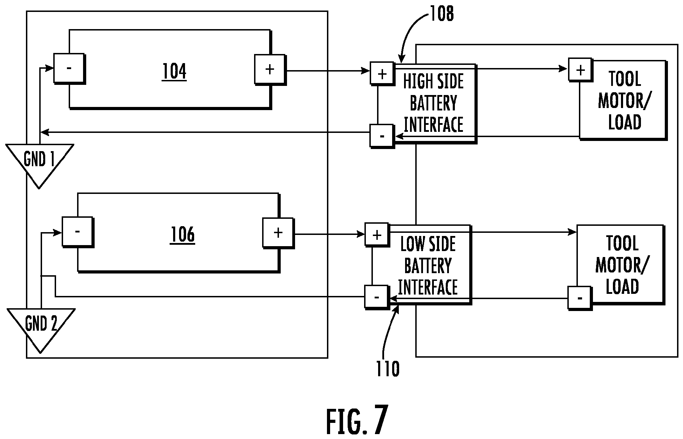

The system 100 and method 200 of FIGS. 3A, 3B, and 4 can be better understood with respect to FIGS. 5-10. Referring particularly to FIGS. 5-7, schematic, simplified diagrams of an embodiment the voltage detection circuit assembly 112 are illustrated. In particular, as shown, to simplify the voltage detection circuit assembly 112, the corresponding voltage supplies have been removed and are simply illustrated as GND1 and GND2. In such embodiments, GND1 and GND2 are the corresponding B- signals of the first and second batteries 104, 106 or supplies that will be used to power the modules. By themselves, there is not an inherent circuit between GND1 and GND2 until the first and second batteries 104, 106 are stacked in series, as shown in FIGS. 5 and 6A. Accordingly, as shown in FIG. 6A, GND1 is referenced at a higher voltage than GND2. Because of the difference in voltage between GND1 and GND2, the Zener diode 126 breaks down, thereby allowing current to flow (as indicated by arrow 128) as shown in FIG. 6A. In contrast, as shown in FIG. 6B, in the event that VGND2 is greater than VGND1, the current flows as shown by arrow 130. Moreover, in the event that the first and second batteries 104, 106 are disconnected, as shown in FIG. 7 (such as running power tools akimbo), the voltages between GND1 and GND2 is not varied. In such embodiments, the voltage detection circuit assembly 112 remains untriggered.

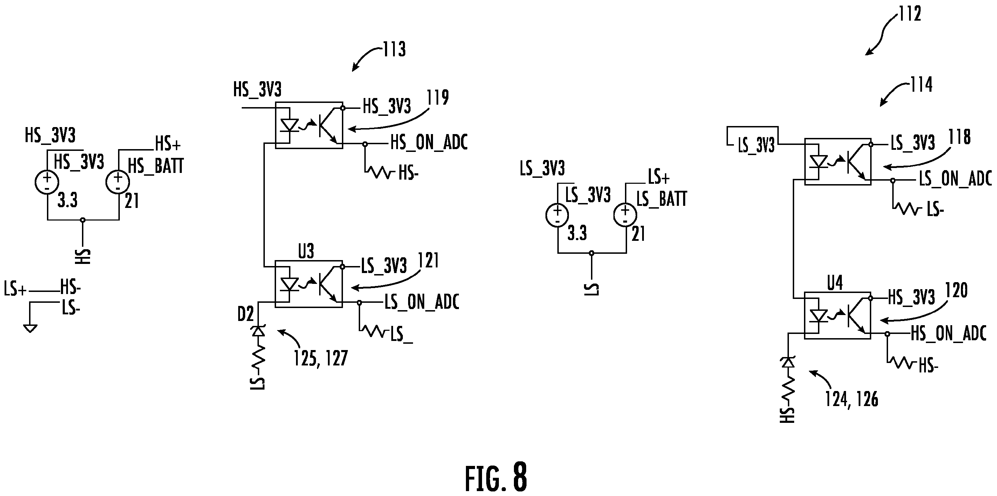

Referring now to FIGS. 8-10, schematic diagrams of embodiments of operation of the voltage detection circuit assembly 112 are illustrated. More specifically, FIG. 8 illustrates a schematic diagram of the voltage detection circuit assembly 112 without any load applied to the circuit. Accordingly, the voltage detection circuit assembly 112 of FIG. 8 abstracts the connections of the first circuit 113 (connected to the high side battery interface 108) and the second circuit 114 (connected to the low side battery interview 110) as two supplies, respectively, labeled HS or LS. Further, as shown, these supplies are simplified to XS_BATT representing the battery voltage (as either HS_BATT or LS_BATT) and XS_3v3 representing an enabled low voltage supply (as either HS_3v3 or LS_3v3).

Thus, as shown in FIG. 9, circled area 132 denotes that LS+ is connected to HS-, thereby creating a 36V battery stack. In such embodiments, the 36V battery stack causes HS_3v3 to appear as a 24.3 V signal. Further, the 24.3 V signal causes the Zener diode 127 to break down and enables current 134 through the optocouplers 119, 121. This current flow 134 also enables both the HS and LS to see a 3.3V signal on its respective general purpose input/output (GPIO) pin. On the other module (LS), the Zener diode 126 sees a negative voltage, therefore, it does not allow current through the series pair of optocouplers 118, 120.

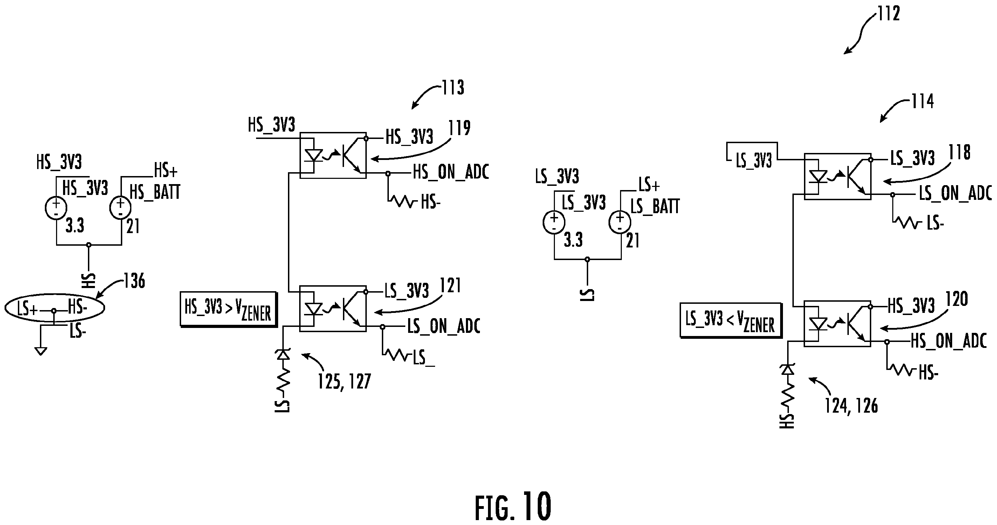

In contrast, as shown in FIG. 10, circled area 136 denotes an LS- and HS-connection to ground, meaning that there is not a method to achieve a higher voltage on the 3.3V signals. As such, neither Zener diode 127 or Zener diode 126 trigger due to the voltage failing to exceed the voltage threshold (e.g., Vzener) of the diodes. In such embodiments, the output of the optocouplers 118, 119, 120, 121 remain tied to the GND reference - or 0V. In other words, the voltage detection circuit assembly 112 can be used to detect a battery pack having a single battery electrically coupled to the common load.

Further aspects of the invention are provided by one or more of the following embodiments:

A battery pack configured to supply power to a common load, the battery pack comprising: at least one battery comprising a high side battery interface and a low side battery interface, the high side and low side battery interfaces electrically coupled to the common load; and a voltage detection circuit assembly configured to perform a plurality of operations, the plurality of operations comprising: determining whether to implement a hardware trigger on only the high side battery interface by referencing ground of the low side battery interface; detecting a load type of the common load based on whether the high side battery interface is triggered; sending a notification to the high side battery interface and the low side battery interface as to whether the high side battery interface is triggered; and in response to sending the notification, determining whether to allow firmware to operate the common load.

The battery pack of any preceding clause, wherein the at least one battery comprises a first battery and a second battery, the first and second batteries together electrically coupled to the common load via the high side battery interface and the low side battery interface, the first battery being connected to a positive side of the high side battery interface, the second battery being connected to a positive side of the low side battery interface.

The battery pack of any preceding clause, wherein the plurality of operations further comprises: connecting the positive side of the low side battery interface to a negative side of the high side battery interface; and connecting a negative side of the low side battery interface to ground.

The battery pack of any preceding clause, wherein determining whether to implement the hardware trigger on only the high side battery interface by referencing the ground of the low side battery interface further comprises: comparing a voltage at the high side battery interface and a voltage at the low side battery interface to a voltage threshold; and implementing the hardware trigger on only the high side battery interface when the voltage at the high side battery interface exceeds the voltage threshold.

The battery pack of any preceding clause, wherein the voltage detection circuit assembly comprises a first circuit and a second circuit, the first circuit comprising a first diode and one or more first isolators, the second circuit comprising a second diode and one or more second isolators.

The battery pack of any preceding clause, wherein determining whether to implement the hardware trigger on only the high side battery interface by referencing the ground of the low side battery interface further comprises: triggering the one or more first isolators when the voltage of the high side battery interface exceeds the voltage threshold and the voltage at the low side battery interface is below the voltage threshold.

The battery pack of any preceding clause, wherein triggering the one or more first isolators when the voltage of the high side battery interface exceeds the voltage threshold and the voltage at the low side battery interface is below the voltage threshold further comprises: using the first diode of the first circuit to trigger the one or more first isolators by allowing current through the one or more first isolators; and using the second diode of the second circuit to prevent current from flowing through one or more second isolators.

The battery pack of any preceding clause, wherein the one or more first isolators and the one or more second isolates comprise one or more optocouplers.

The battery pack of any preceding clause, wherein at least one of the first diode and the second diode is a Zener diode.

The battery pack of any preceding clause, wherein the at least one battery comprises a single battery electrically coupled to the common load via the high side battery interface and the low side battery interface, wherein a negative side of the high side battery interface and a negative side of the low side battery interface to ground.

The battery pack of any preceding clause, wherein determining whether to allow firmware to operate the common load further comprises one of allowing the firmware to operate the common load when the high side battery interface is triggered or preventing the firmware from operating the common load when the high side battery interface is not triggered.

The battery pack of any preceding clause, wherein the common load is a power tool.

The battery pack of any preceding clause, wherein the load type comprises one of an 18-volt power tool or a 36-volt power tool.

A method for detecting voltage of a load connected to a battery pack, the method comprising: determining, via a voltage detection circuit assembly, whether to implement a hardware trigger on only a high side battery interface of the battery pack by referencing ground of a low side battery interface of the battery pack; detecting, via the voltage detection circuit assembly, a load type of the load based on whether the high side battery interface is triggered; sending, via the voltage detection circuit assembly, a notification to the high side battery interface and the low side battery interface as to whether the high side battery interface is triggered; and in response to sending the notification, determining, via the voltage detection circuit assembly, whether to allow firmware of the battery pack to operate the load.

The method of any preceding clause, wherein the battery pack comprises a first battery and a second battery, the first and second batteries together electrically coupled to the load via the high side battery interface and the low side battery interface, the first battery being connected to a positive side of the high side battery interface, the second battery being connected to a positive side of the low side battery interface, the method further comprising: connecting the positive side of the low side battery interface to a negative side of the high side battery interface; and connecting a negative side of the low side battery interface to ground.

The method of any preceding clause, wherein determining whether to implement the hardware trigger on only the high side battery interface of the battery pack by referencing ground of the low side battery interface of the battery pack further comprises: comparing a voltage at the high side battery interface and a voltage at the low side battery interface to a voltage threshold; and implementing the hardware trigger on only the high side battery interface when the voltage at the high side battery interface exceeds the voltage threshold.

The method of any preceding clause, wherein the voltage detection circuit assembly comprises a first circuit and a second circuit, the first circuit comprising a first diode and one or more first isolators, the second circuit comprising a second diode and one or more second isolators.

The method of any preceding clause, wherein determining whether to implement the hardware trigger on only the high side battery interface by referencing the ground of the low side battery interface further comprises: triggering the one or more first isolators when the voltage of the high side battery interface exceeds the voltage threshold and the voltage at the low side battery interface is below the voltage threshold.

The method of any preceding clause, wherein triggering the one or more first isolators when the voltage of the high side battery interface exceeds the voltage threshold and the voltage at the low side battery interface is below the voltage threshold further comprises: using the first diode of the first circuit to trigger the one or more first isolators by allowing current through the one or more first isolators; and using the second diode of the second circuit to prevent current from flowing through one or more second isolators.

The method of any preceding clause, wherein the one or more first isolators and the one or more second isolates comprise one or more optocouplers, and wherein at least one of the first diode and the second diode is a Zener diode.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal language of the claims.

## Claims

1. A battery pack configured to supply power to a common load, the battery pack comprising:
at least one battery comprising a high side battery interface and a low side battery interface, the high side and low side battery interfaces electrically coupled to the common load; and
a voltage detection circuit assembly configured to perform a plurality of operations, the plurality of operations comprising:
determining whether to implement a hardware trigger on only the high side battery interface by referencing ground of the low side battery interface;
detecting a load type of the common load based on whether the high side battery interface is triggered;
sending a notification to the high side battery interface and the low side battery interface as to whether the high side battery interface is triggered; and
in response to sending the notification, determining whether to allow firmware to operate the common load.

2. The battery pack of claim 1, wherein:
the at least one battery comprises a first battery and a second battery, the first and second batteries together electrically coupled to the common load via the high side battery interface and the low side battery interface, the first battery being connected to a positive side of the high side battery interface, the second battery being connected to a positive side of the low side battery interface; and
the plurality of operations further comprises:
connecting the positive side of the low side battery interface to a negative side of the high side battery interface; and
connecting a negative side of the low side battery interface to ground.

3. The battery pack of claim 2, wherein determining whether to implement the hardware trigger on only the high side battery interface by referencing the ground of the low side battery interface further comprises:
comparing a voltage at the high side battery interface and a voltage at the low side battery interface to a voltage threshold; and
implementing the hardware trigger on only the high side battery interface when the voltage at the high side battery interface exceeds the voltage threshold.

4. The battery pack of claim 3, wherein:
the voltage detection circuit assembly comprises a first circuit and a second circuit, the first circuit comprising a first diode and one or more first isolators, the second circuit comprising a second diode and one or more second isolators; and
determining whether to implement the hardware trigger on only the high side battery interface by referencing the ground of the low side battery interface further comprises:
triggering the one or more first isolators when the voltage of the high side battery interface exceeds the voltage threshold and the voltage at the low side battery interface is below the voltage threshold.

5. The battery pack of claim 4, wherein triggering the one or more first isolators when the voltage of the high side battery interface exceeds the voltage threshold and the voltage at the low side battery interface is below the voltage threshold further comprises:
using the first diode of the first circuit to trigger the one or more first isolators by allowing current through the one or more first isolators; and
using the second diode of the second circuit to prevent current from flowing through one or more second isolators.

6. The battery pack of claim 5, wherein the one or more first isolators and the one or more second isolates comprise one or more optocouplers; and wherein at least one of the first diode and the second diode is a Zener diode.

7. The battery pack of claim 1, wherein the at least one battery comprises a single battery electrically coupled to the common load via the high side battery interface and the low side battery interface, wherein a negative side of the high side battery interface and a negative side of the low side battery interface to ground.

8. The battery pack of claim 1, wherein determining whether to allow firmware to operate the common load further comprises one of allowing the firmware to operate the common load when the high side battery interface is triggered or preventing the firmware from operating the common load when the high side battery interface is not triggered.

9. The battery pack of claim 1, wherein the common load is a power tool.

10. The battery pack of claim 9, wherein the load type comprises one of an 18-volt power tool or a 36-volt power tool.

11. A method for detecting voltage of a load connected to a battery pack, the method comprising:
determining, via a voltage detection circuit assembly, whether to implement a hardware trigger on only a high side battery interface of the battery pack by referencing ground of a low side battery interface of the battery pack;
detecting, via the voltage detection circuit assembly, a load type of the load based on whether the high side battery interface is triggered;
sending, via the voltage detection circuit assembly, a notification to the high side battery interface and the low side battery interface as to whether the high side battery interface is triggered; and
in response to sending the notification, determining, via the voltage detection circuit assembly, whether to allow firmware of the battery pack to operate the load.

12. The method of claim 11, wherein the battery pack comprises a first battery and a second battery, the first and second batteries together electrically coupled to the load via the high side battery interface and the low side battery interface, the first battery being connected to a positive side of the high side battery interface, the second battery being connected to a positive side of the low side battery interface, the method further comprising:
connecting the positive side of the low side battery interface to a negative side of the high side battery interface; and
connecting a negative side of the low side battery interface to ground.

13. The method of claim 12, wherein determining whether to implement the hardware trigger on only the high side battery interface of the battery pack by referencing ground of the low side battery interface of the battery pack further comprises:
comparing a voltage at the high side battery interface and a voltage at the low side battery interface to a voltage threshold; and
implementing the hardware trigger on only the high side battery interface when the voltage at the high side battery interface exceeds the voltage threshold.

14. The method of claim 13, wherein:
the voltage detection circuit assembly comprises a first circuit and a second circuit, the first circuit comprising a first diode and one or more first isolators, the second circuit comprising a second diode and one or more second isolators; and
determining whether to implement the hardware trigger on only the high side battery interface by referencing the ground of the low side battery interface further comprises:
triggering the one or more first isolators when the voltage of the high side battery interface exceeds the voltage threshold and the voltage at the low side battery interface is below the voltage threshold.

15. The method of claim 14, wherein:
triggering the one or more first isolators when the voltage of the high side battery interface exceeds the voltage threshold and the voltage at the low side battery interface is below the voltage threshold further comprises:
using the first diode of the first circuit to trigger the one or more first isolators by allowing current through the one or more first isolators, and
using the second diode of the second circuit to prevent current from flowing through one or more second isolators;
the one or more first isolators and the one or more second isolates comprise one or more optocouplers; and
at least one of the first diode and the second diode is a Zener diode.
